# EUROPEAN PATENT APPLICATION

(11) **EP 3 614 413 A1**
(43) Date of publication of application: **26.02.2020**
(21) Application number: 18190666.0
(22) Date of filing: 24.08.2018
(51) Int. Cl.: H01J 37/244, G01T 1/24, H01L 31/0312, G01T 1/29

(54) **SILICON CARBIDE DETECTORS WITH IMPROVED RELIABILITY FOR PHOTON AND/OR ION BEAMS**

(71) Applicant: PAUL SCHERRER INSTITUT, 5232 Villigen PSI (CH)
(72) Inventor: CAMARDA, Massimo, 5200 Brugg (CH)
(74) Representative: Fischer, Michael

(57) **Abstract**

It is the objective of the present invention to achieve a reduction of the heat load (i.e. operating temperature) of Silicon Carbide X-ray detectors, more specifically of X-ray beam position monitors (XBPMs), under high intensity beams, e.g. pink and white beams at SLS.

This objective is achieved according to the present invention by a photon and/or ion beam position detector (XBPM), comprising:
a) a substrate (2);
b) an electrically active membrane (4) being supported by the substrate (2) wherein the electrically active membrane (4) is substantially made from Silicon Carbide;
c) a number of electrodes (8 to 12) being disposed on the substrate (4) and on the electrically active membrane (4); the electrodes (8to 12) being connected to a driving and current measuring circuitry (14), thereby allowing a current to flow upon activation by the x-ray and/or the ion beam through the electrically active membrane (4);
and
d) a carbon based layer (18, 20) that is disposed at least partially on the surface of the electrically active membrane (4) and/or at least partially on the surface of the number of electrodes (8 to 12).

By the separation of the electrically active area of the XBPM from the heat sink regions realized with the carbon based layer, the detector achieves a reduction of the heat load and maintains the advantages provided by the use of a SiC electrically active membrane.

## Description

The present invention relates to improved designs for Silicon Carbide photons and/or ions beams detectors.

Currently, in the case of very intense photons and/or ions beams, Diamond is the material of choice for detectors thanks, among others, to its high melting point, high required energy for atoms displacement, wide band gap and low beam absorption.

As a specific example Diamond x-ray beam position detectors are currently used for the control of the beam position in experimental beam lines at Synchrotron Light Sources. These detectors are referred as "intercepting four-quadrant X-ray beam position detectors" (XBPM).

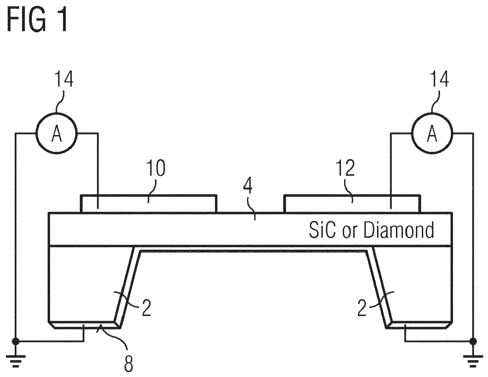

As shown in Figure 1, an XBPM comprises a substrate 2 and an electrically active membrane, i.e. a centrally placed free standing region, 4 being supported by the substrate 2. A number of electrodes 8, 10, 12 being disposed on the substrate 2 and on the electrically active membrane 4; said electrodes 8 to 12 being connected to a driving and current measuring circuitry 14, thereby allowing a current to flow upon activation by the x-ray and/or the ion beam through the electrically active membrane 4. The electrically active membrane 4 is operated by the circuitry 14 like a solid-state ion chamber, typically at electric fields of around 10 kV/cm. The measured currents allow to determine the position of the x-ray beam. Such detectors are for example disclosed under www.dectris.com (RIGI® detector), www.cividec.at and www.synchrotron-soleil.fr

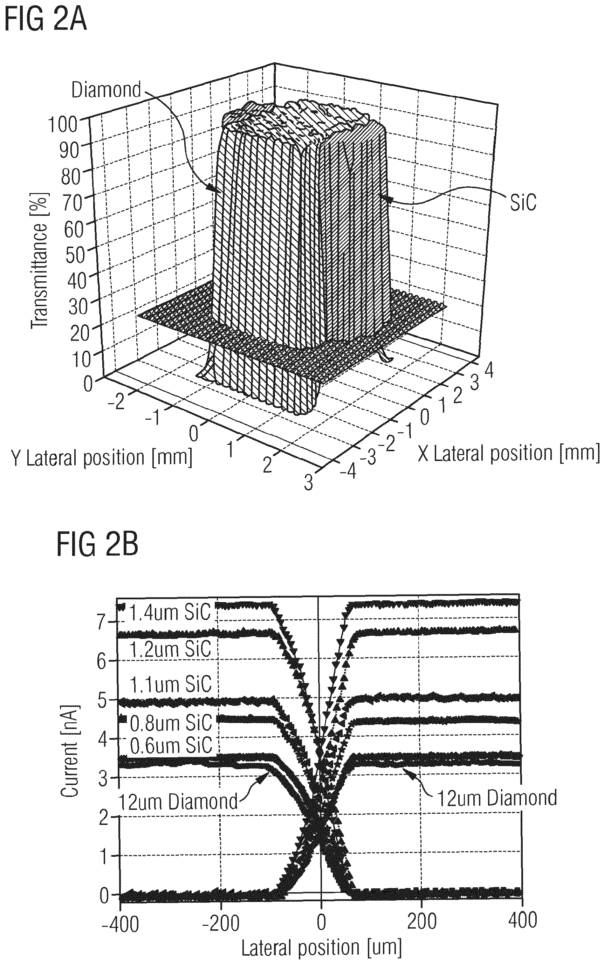

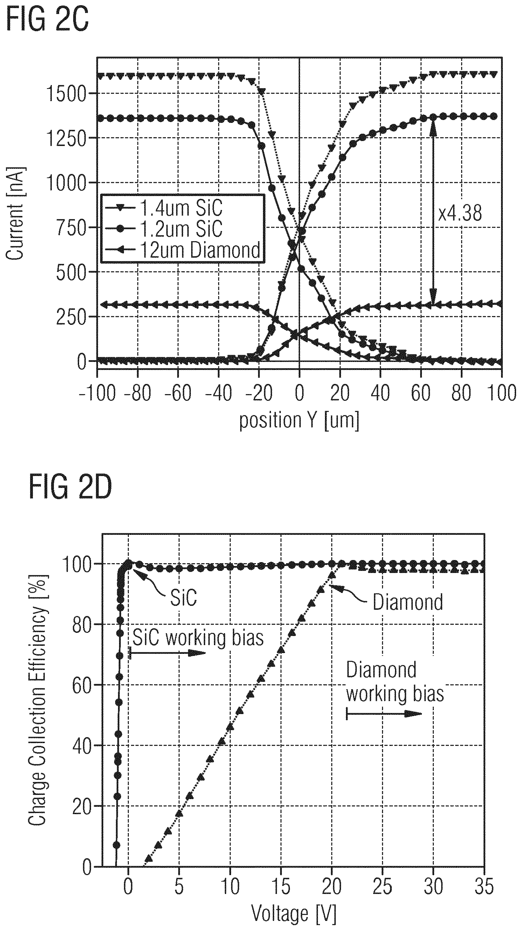

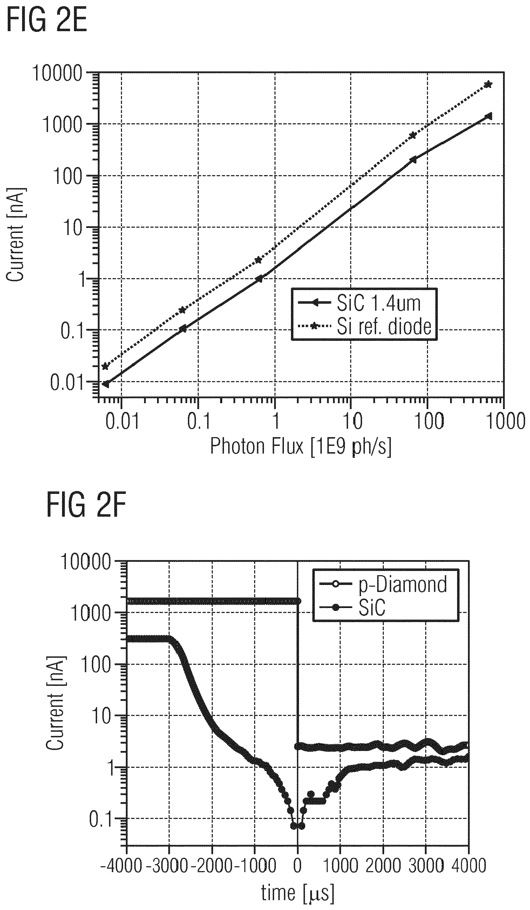

Recently Silicon Carbide was tested as an alternative to Diamond for XBPM usage in synchrotron facilities. The first realized SiC XBPMs, obtained thanks to a newly developed doping selective electrochemical etching process, filed the 29/03/2018 to the European Patent Office under the application number EP 18165088.8, showed superior characteristics when compared to both polycrystalline and single crystal Diamond ones, specifically showing:
a) Transparencies equivalent to commercial polycrystalline XBPM devices (RIGI, from DECTRIS) and more than 5 times superior transparencies as compared to single-crystal ones (from CIVITEC), >98% at 12.4keV, see Fig.2A
b) Superior and higher (x4.38) signal uniformity when compared to RIGI devices, see Fig.2B and 2C.
c) Saturated charge collection efficiency already at zero external bias, Fig.2D, thanks to the internal built-in voltage of the p-n diode.
d) Linearity of the electrical response over more than 4 orders of magnitude, Fig.2E.
e) Faster electrical response to beam variations, below micro seconds. More than 3 orders of magnitude better as compared to RIGI devices.

Given the obtained results and availability of electronic grade epitaxies on up to 6-inch wafers, as compared to few mm² and cm² for single crystal and polycrystalline diamond respectively, Silicon Carbide will most likely substitute diamond XBPMs in most beam monitoring applications.

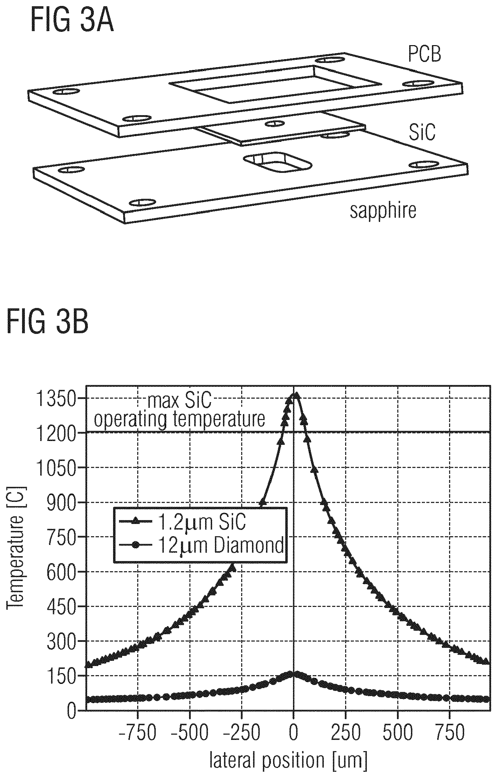

The current limit on the applications of this material comes from its higher (x10) X-ray absorption when compared to Diamond. This difference induces higher operating temperatures when compared to Diamond ones. This limitation becomes important in the case of high-energy X-ray beams (e.g. synchrotron pinkbeams) as it can rise the operating temperature above the device critical one (around 1200°C for SiC). As can be seen in Fig.3(b), the operating temperature, obtained by Finite Element Simulations, under a typical pinkbeam and for properly cooled devices is around ∼1350°C, i.e. well above the one of Diamond (around 40°C) and above the critical operating temperature. Preliminary experimental tests supported these theoretical results by showing a very fast degradation of the devices.

It is therefore the objective of the present invention to achieve a reduction of the heat load (i.e. operating temperature) of Silicon Carbide detectors, more specifically of X-ray beam position monitors (XBPMs), under high intensity beams, e.g. pink and white beams at SLS.

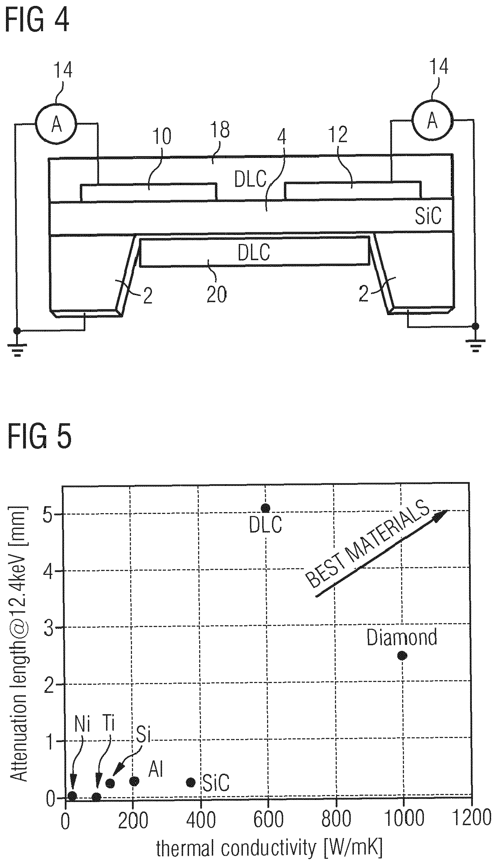

To take advantage of the superior electrical properties of Silicon Carbide, and in the same time avoid thermal runaways under high intense beams the present invention proposes to separate the electrically active part of the XBPM (4) from the heat sinks (18) as presented schematically in Fig. 4 as compared to the standard design of Fig.1.

By the separation of the electrically active area of the XBPM from the heat sink regions the detector achieves a reduction of the heat load and maintains the advantages provided by the use of Silicon Carbide as electrically active detector. Based on Fig.5, which shows the two most critical optical properties of different materials, namely the attenuation length and the thermal conductivity, we identify Aluminum as best metal layer (as compared to the normally used Nickel) and Diamond Like Carbon, DLC, as possible heat sink (or alternatively other carbon based ones).

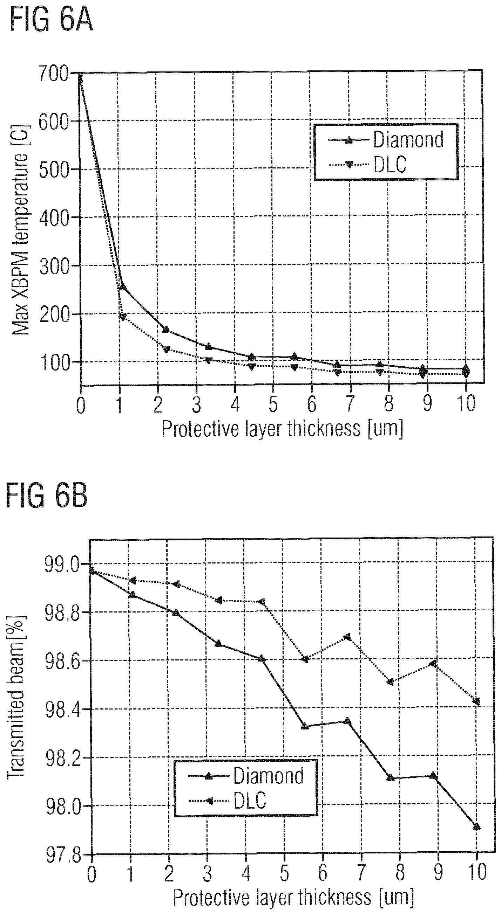

This improved design has been simulated, obtaining, in the case of 1.2um SiC XBPM with 50nm Al contacts, observing a strong decrease of the operating temperature already for thin, 1um, layers (Fig.6). Fig. 6 (a) depicts the maximal operating temperature and (b) the transmitted beam for a 1.2um SiC XBPM with 50nm Al and different protective layers thicknesses.

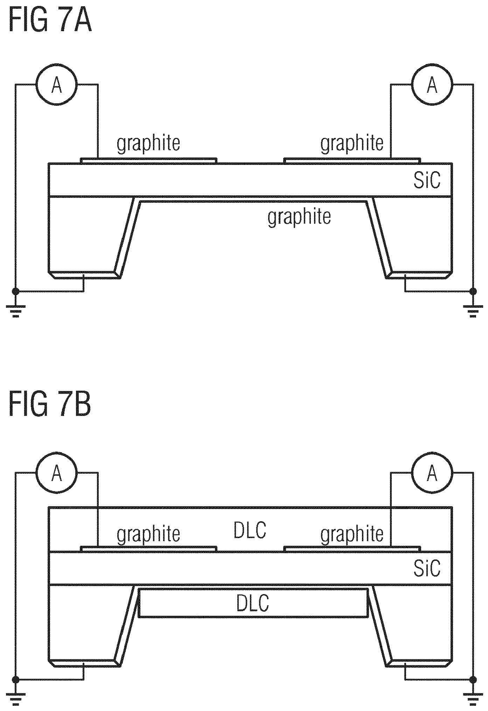

Furthermore, the usage of such design and DLC as protective heat sink layer has also other benefits besides the temperature reduction of the XBPM, namely:
- The DLC protects the metal contacts from deterioration.
- The deposition of DLC is cheaper and can be performed on large wafers, as compared to the CVD deposition of Diamond.
- The DLC can be of any type, allowing for very low densities layers, resulting in very high attenuation lengths (Fig. 5) and thus allowing for overall higher XBPM transparencies (see Fig. 7b).

Finally, in Silicon Carbide is possible to epitaxially grow high quality graphene/graphite layers. Such layers could be used instead of the DLC one not only heat diffusion but also as substitute for metal layers, as this is shown in Fig.7 (a) or in combination to DLC to achieve even higher transparencies and lower operating temperatures (see Fig.7(b)).

Embodiments of the present invention will comprise:
a) A substrate.
b) An electrically active membrane, i.e. a centrally placed free standing region, being supported by the substrate and wherein the electrically active membrane is substantially made from Silicon Carbide.
c) A number of electrodes being disposed on the substrate and on the electrically active membrane; each electrode being connected to a separate driving and measuring circuitry, thereby allowing a current to flow upon activation by the x-ray and/or the ion beam through the electrically active membrane.
d) A heat sink layer that is disposed at least partially on the surface of the electrically active membrane and/or at least partially on the surface of the number of electrodes.

Preferred embodiments of the present invention may comprise one or more of the following features:
a) The carbon based layers are made of Diamond like carbon and/or amorphous Carbon and/or graphite.
b) The carbon based layer is dielectric and used for heat dissipation and as protection layer.
c) The carbon based layer is conductive and used for heat dissipation and currents flow.
d) The thickness of the electrically active membrane and the carbon based layer is chosen to allow x-ray beams and/or high energy/high fluxes photons, such as generated by synchrotrons and/or free electron lasers, to go through at least at a level of 80%.
e) The thickness of the electrically active membrane and the carbon based layer is chosen to allow ion beams, such as generated by cyclotrons, to go through at least at a level of 80%.
f) The electrically active membrane is built as a thin freestanding layer to achieve high beam transparency, such layer preferably having a thickness in range of a few microns or even in nano-range.

Preferred embodiment of the present invention are hereinafter described in more detail with reference to the attached drawing that depicts in:
- Figure 1: A standard XBPM detector comprising a substrate *2* and an electrically active/transparent membrane *4*. A number of electrodes *8*, *10*, *12* being disposed on the substrate *2* and on the electrically active membrane *4*; said electrodes *8* to *12* being connected to a driving and current measuring circuitry 14.
- Figure 2: Overall experimental results on SiC XBPMs.
- Figure 3: (a) elements composing a full SiC XBPM chip and (b) simulated temperature profiles across the SiC XBMP; Finite element thermal simulations were performed considering the focused pinkbeam setup at the OPTICS beamline at the SWISS LIGHT SOURCE at Paul Scherrer Institute, Villigen, Switzerland (SLS). The considered beamline, in the focused pinkbeam configuration, has a averaged power density of 18kW/cm², photon energies from 4keV to 20keV with maximum at 10keV and a spot of 100um FWHM.
- Figure 4: An improved design using DLC or Diamond only as heat sink regions and the thin SiC layer as only electrically active layer.
- Figure 5: Optical and thermal properties for different materials; properties of Diamond like Carbon (DLC) are strongly dependent on the specific growth, and have been thus averaged.
- Figure 6: (a) The maximal operating temperature and (b) the transmitted beam for a 1.2um SiC XBPM with 50nm Al and different protective layers
- Figure 7: (a) An improved design using graphite/graphene layers as heat sink regions and as substitute to metal contacts (b) Combination of graphite/graphene and DLC layers for improved reliability and beam transmission.

Figure 1 shows a standard XBPM detector. The standard XBPM detector comprises a substrate 2 and an electrically active/transparent membrane 4. A number of electrodes 8, 10, 12, disposed on the substrate 2 and on the electrically active membrane 4. Said electrodes 8 to 12 are connected to a driving and measuring circuitry 14.

Fig.4 shows an improved XBPM design which, as compared to the standard design, contains additional layers, here a Diamond like carbon layer 18, 20 disposed at least partially on the surface of the electrically active membrane 4 and/or at least partially on the surface of the number of electrodes 8 to 12. Upper DLC layer 18 covers in this embodiment the upper part of the XBPM while a lower DLC layer 20 covers the bottom part of the XBPM. This solution allows to take advantage of the superior electrical properties of Silicon Carbide but use the DLC as heat sink, avoiding thermal runaways under high intense beams.

Fig.5 shows the two most critical optical properties of different materials, namely the attenuation length and the thermal conductivity. Best materials for X-ray beam monitor will show large attenuation length and high thermal conductivities. From it we identify Aluminum as best metal layer (as compared to the normally used Nickel) and Diamond Like Carbon, DLC, as possible best heat sink (or alternatively other carbon based ones).

Fig.7 (a) shows an alternative design which avoids to use Aluminum as metal contact, using instead graphene/graphite, this will result improved beam transmission. Fig.7(b) shows a combination of graphite/graphene and DLC layers for improved reliability and beam transmission.

## Claims

1. Photon and/or ion beam position detector (XBPM), comprising:
a) a substrate (2);
b) an electrically active membrane, i.e. an electrically active free standing region, (4) being supported by the substrate (2), wherein the membrane (4) is substantially made from Silicon Carbide;
c) a number of electrodes (8 to 12) being disposed on the substrate (4) and on the electrically active membrane (4); the electrodes (8 to 12) being connected to a measuring circuitry (14), thereby allowing a current to flow upon activation by the x-ray and/or the ion beam through the electrically active membrane (4);
d) a carbon based layer (18, 20) that is disposed at least partially on the surface of the electrically active membrane (4) and/or at least partially on the surface of the number of electrodes (8 to 12).

2. Photon and/or ion beam detector according to claim 1, wherein the carbon based layers (18, 20) are made of Diamond like carbon and/or amorphous Carbon and/or graphite.

3. Photon and/or ion beam detector according to claim 1 or 2, wherein the carbon based layer (18, 20) is dielectric and used for heat dissipation and as protection layer.

4. Photon and/or ion beam detector according to claim 1 or 2, wherein the carbon based layer (18, 20) is conductive and used for heat dissipation and currents flow.

5. Photon and/or ion beam detector according to claim 1 or 2, wherein the carbon based layer (18, 20) is for some part conductive and used for heat dissipation and currents flow and for some part dielectric and used for heat dissipation and as protection layer.

6. Photon and/or ion beam detector according to any of the preceding claims 1 to 4, wherein the thickness of the electrically active membrane (4) and the carbon based layer (18, 20) is chosen to allow beams to go through at least at a level of 60%, preferably at least at a level of 95%.

7. Photon and/or ion beam detector according to any of the preceding claims, wherein the electrically active free standing layer (4), built to achieve high beam transparency, has preferably a thickness in range of a few microns or even in nano-range.

8. Photon and/or ion beam detector according to any of the preceding claims, wherein the detector, having a multiplicity of electrodes, allows determining not only the beam intensity but also its position (beam monitoring position).
